Europäisches Patentamt

European Patent Office

Office européen des brevets

(19)

(11) Publication number: **0 107 912**
**B1**

(12) **EUROPEAN PATENT SPECIFICATION**

(45) Date of publication of patent specification: **24.02.88**

(51) Int. Cl.⁴: **G 11 C 11/40**

(21) Application number: **83305712.8**

(22) Date of filing: **26.09.83**

(54) Semiconductor memory device.

(30) Priority: **27.09.82 JP 166709/82**

(43) Date of publication of application:
**09.05.84 Bulletin 84/19**

(45) Publication of the grant of the patent:
**24.02.88 Bulletin 88/08**

(84) Designated Contracting States:
**DE FR GB**

(56) References cited:
**EP-A-0 053 504**

**IBM TECHNICAL DISCLOSURE BULLETIN, vol. 16, NO. 8, January 1974, New York (US), pages 2647-8 E.FEICHT et al.: "Bipolar driver for field-effect transistor circuits"**

**MICROELECTRONICS JOURNAL, vol. 11 No. 5, Sept./Oct. 1980, LUTON (GB) W.H. HERNDON et al.: 4096 bit and larger bipolar static random access memories", pages 12-14**

(73) Proprietor: **FUJITSU LIMITED**
**1015, Kamikodanaka Nakahara-ku**
**Kawasaki-shi Kanagawa 211 (JP)**

(72) Inventor: **Toyoda, Kazuhiro**
**859-1 Kandaijimachi Kanagawa-ku**
**Yokohama-shi Kanagawa 211 (JP)**

(74) Representative: **Rackham, Stephen Neil et al**
**GILL JENNINGS & EVERY 53-64 Chancery Lane**
**London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a semiconductor memory circuit, more particularly to a static type bipolar random access memory RAM.

Recent research and development in semiconductor memory circuits have concentrated in achieving high densities of packaging, high speed operation and low power consumption.

A semiconductor memory circuit generally comprises a plurality of memory cells, bit lines, word lines, a bit line driver circuit and a word line driver circuit for driving these these bit lines and word lines, a bit decoder and a word decoder for selecting a desired bit line and word line, and so on. Each of the above components serves in some way to achieve at least one of the above objects. Of these components, the present invention mainly relates to the bit line driver circuit and aims at high speed operation and low power consumption.

European Patent Application No. 81305640.5, publication No. 0 053 504 discloses a semiconductor memory circuit comprising a plurality of bit line pairs; a plurality of word line pairs; a plurality of memory cells connected to the bit line pairs and word line pairs; bit line switching transistor pairs connected in series with their respective bit line pairs; constant current sources connected to the emitters of the bit line switching transistors at one side of each of the bit line switching transistor pairs and to emitters of the bit line switching transistors at the other side of each of the bit line switching transistors, respectively; bit line driver circuits operative to supply their outputs to the bases, connected in common, of the transistors forming the bit line switching transistor pairs; and a discharge path connected to the commonly connected bases, in which each of the bit line driver circuits includes a first transistor being driven in accordance with a corresponding bit line selection address input and a level shift means connected in series with the first transistor, and commonly connected bases of the corresponding one of the pairs of bit line switching transistors for shifting a voltage level, the base of the first transistor receiving base current, via a first resistor, from a power source.

According to this invention in such a semiconductor memory circuit the level shift means in each of the bit line driver circuits is formed by a second transistor having a base operatively connected to the emitter of the first transistor and an emitter operatively connected to the commonly connected bases of the corresponding one of the pairs of bit line switching transistors to provide an amplification factor of $\beta$.

A particular example of a semiconductor memory device in accordance with the present invention will now be described and contrasted with the prior art with reference to the accompanying drawings; in which:—

Figure 1 is a circuit diagram of a major part of a prior art semiconductor memory circuit;

Figure 2 is a graph of voltage against time showing the waveforms of level changes at output points in the prior art circuit;

Figure 3 is a circuit diagram of the present invention; and,

Figure 4 is a graph of voltage against time showing the waveforms of level changes at output points in the circuit in accordance with this invention.

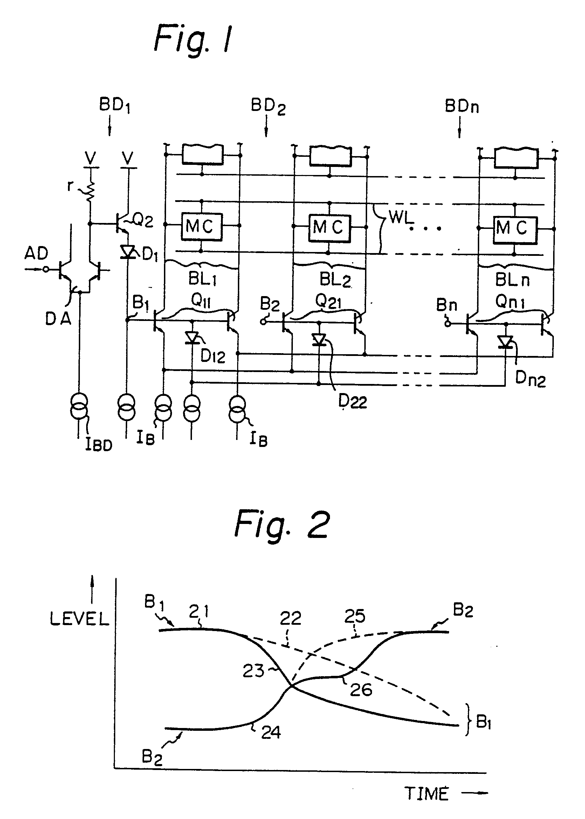

Figure 1 is a brief circuit diagram of a major part of the prior art semiconductor memory circuit. In Figure 1, reference characters BL1, BL2, ... Bln represent bit line pairs and WL represents word line pairs. Each of the bit line pairs is provided with a plurality of memory cells MC. The bit line pairs $BL_1$, $BL_2$—$BL_n$ are connected in series with bit line switching transistor pairs $Q_{11}$, $Q_{21}$—$Q_{n1}$ and further, connected to a constant current source pair $I_B$. In this case, emitters on one side of each bit line switching transistor pair $Q_{11}$, $Q_{21}$—$Q_{n1}$ are connected in common. Also emitters on the other side are connected in common, as diagrammed. Thus, these switching transistor pairs form a so-called current switch. Therefore, at any one time, only one of the bit line pairs is active, which is advantageous in view of low power consumption.

Which of the bit line pairs is to be selected is specified in accordance with a bit line selection address input AD provided from a bit decoder (not shown). The address input AD drives the bit line driver circuit (BD), via a differential amplifier DA. In this figure, only one bit line driver circuit $BD_1$ cooperating with the corresponding bit line pair $BL_1$ is concretely illustrated for brevity. The output from the circuit $BD_1$ is applied, via an output point $B_1$, to the common base of the bit line switching transistor pair $Q_{11}$. Other bit line driver circuits $BD_2$—$BD_n$ having output points $B_2$—Bn have the same construction as that of the abovementioned circuit $BD_1$.

When the bit line pair $BL_1$ is selected, the left side transistor of the differential amplifier DA is turned on, while the right side transistor thereof is turned off, by the address input AD. Then, an emitter follower transistor $Q_2$ is turned on. Therefore, a signal of "H" (high) level is applied, via a diode $D_1$ as a level shifter, to the common base of the bit line switching transistor pair $Q_{11}$. Thereby, both transistors of the transistor pair $Q_{11}$ are turned on. In this case, an "H" level signal appears at the output point $B_1$ and, at the same time, held as it is during the concerned selection state.

Suppose that a selection bit line is then switched from the bit line $BL_1$ to the bit line $BL_2$. At this time, the voltage level at the output point $B_1$ is changed from "H" to "L" (low), while the voltage level at the output point $B_2$ is changed from "L" to "H". The advantage of the circuit shown in Fig. 1 resides in the high speed switching from "H" to "L" at the output point $B_1$, or more generally, the high speed switching from a selection state to a nonselection state at any one of the bit line pairs. An explanation of the word line (WL) selection is omitted, since the word line selection is achieved as usual and not relevant to the present invention.

Figure 2 depicts waveforms representing level changes at the output points $B_1$ and $B_2$ in the circuit of Fig. 1. Ideally, the voltage level of the output point $B_1$ should change as shown by the solid lines 21 and 23 and the voltage level of the output point $B_2$ should change as shown by the solid line 24 and the broken line 25.

If it were not for the diodes $D_{12}$, $D_{22}$—$D_{n2}$, the voltage level at the output point $B_1$ would change as shown by the solid line 21 to broken line 22, i.e., would change slowly rather than rapidly. The reason for this is that charges stored in a parasitic capacitor at the output point $B_1$ (the same applies to the output points $B_2$—$B_n$) cannot be discharged quickly.

In order to achieve quick discharge, however, the prior art circuit of Fig. 1 provided diodes $D_{12}$, $D_{22}$—$D_{n2}$ as discharge paths at the bit line switching transistor pairs. Thus, the changes at the output point $B_1$ can quickly be discharged and, therefore, a quick level change at the point $B_1$ is performed. In this case, the falling voltage level at the point $B_1$ (line 23) soon crosses the rising voltage level at the point $B_2$ (line 24) of the bit line pair $BL_2$ to be selected next. This makes it possible to shorten the so-called access time, an object of the circuit shown in Fig. 1.

In actuality, however, the access time is often not as short as intended, although the level at the point $B_1$ can quickly fall. That is, the level at the output point $B_2$ does not always change along line 24 to a broken line 25 as intended, but often changes slowly, as shown by a solid line 26. Accordingly, the level difference between points $B_1$ and $B_2$ cannot quickly be increased and it takes too long for the predetermined level difference to be reached. This means that high speed operation of the memory cannot completely be guaranteed.

The present invention guarantees to provide the intended level change. Therefore, the aforesaid level difference is always increased quickly.

First, it should be noted why the level of the point $B_2$ does not always change as intended in the prior art semiconductor memory circut. According to the previously mentioned example, the bit line pair $BL_2$ is selected next to the bit line pair $BL_1$. In this case, the corresponding bit line driver circuit $BD_2$ is made active. (The circuit $BD_2$ is not illustrated for brevity in Fig. 1, but has the same construction as the circuit $BD_1$). That is, a transistor $Q_2$ of $BD_2$ is turned on. Soon after this, a base current starts flowing through a resistor r of $BD_2$. Simultaneously, a voltage drop occurs across the resistor r of $BD_2$. This voltage drop appears, through a diode $D_1$ of $BD_2$, at the output point $B_2$, thus slowing down the rise of the level of point $B_2$, as shown by the recess on the curve 26. In this regard, the resistor should have sufficiently low resistance so as to reduce the voltage drop. However, the tendency is to increase the resistance thereof, along with the increase in the packaging density of an integrated circuit (IC). This is because, the higher the packaging density, the larger the power consumption of the IC. Therefore, the resistors should have high resistance so as to reduce the power consumption and, thereby, present deleterious heat increase in the IC.

The present invention can guarantee such a reduced voltage drop, even in a packaged IC with a high density having resistors r of high resistances. Thus, high speed operation of the memory is guaranteed.

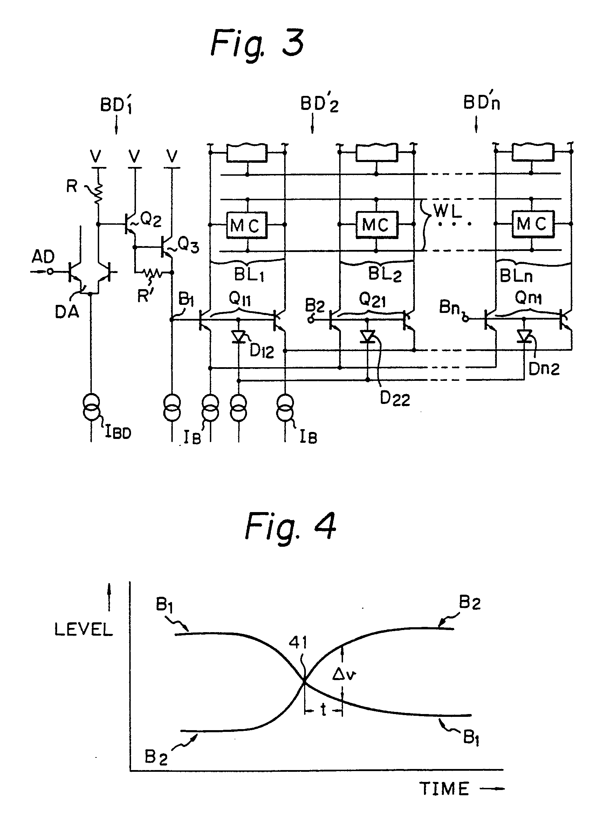

Figure 3 is a circuit diagram of a semiconductor memory circuit according to an embodiment of the present invention. In Fig. 3, members the same as those of Fig. 1 are represented by the same reference characters. The difference here is that, in an improved bit line driver circuit $BD_1'$ (same applies to other improved bit line driver circuits $BD_2'$—$BD_n'$), the diode $D_1$ of Fig. 1 is replaced with a transistor $Q_3$.

The transistor $Q_3$, which has an amplification factor of $\beta$, and the transistor $Q_2$ are constructed in the form of a so-called Darlington circuit. Accordingly, the base current for the transistor $Q_2$ of Fig. 3, needed to supply the same current to the output point B (representative of $B_1$, $B_2$—$B_n$) as that of Fig. 1, can be lowered by

$$\frac{1}{\beta}$$

compared with the base current for the transistor $Q_2$ of Fig. 1. As a result, the voltage drop created by the above-mentioned base current across the resistor r of Fig. 3 is a lowered by about

$$\frac{1}{\beta}$$

too, compared with the one created across the resistor r of Fig. 1.

This means that there is no possiblity of slowing down the rise of the voltage level of point $B_2$ even if the resistance of the resistor r is high. As previously mentioned, the undesired slowdown of the rise of the voltage level is derived from the voltage drop across an inevitably high resistance resistor r by the base current flowing therethrough to the transistor $Q_2$. Thus, the smaller the base curent flowing through the resistor r, the lower the voltage drop, and, therefore, the higher the resistance of r can be.

Incidentally, it should be recognized that the desired level shift function effected by the diode $D_1$ of Fig. 1 is still maintained, although no such diode $D_1$ is used in the circuit of Fig. 3, by a base-emitter diode junction of the transistor $Q_3$.

The aforesaid $\beta$ of the transistor $Q_3$ is usually a value of about 200. Therefore, the base current for the transistor $Q_2$ is extremely reduced. In this regard, the resistor r of Fig. 1 may be replaced with a resistor of high resistance, conversely, such as resistor R of Fig. 3 having a resistance value of $\alpha$r, where r represents here the resistance value of the resistor r in Fig. 1. In this case, the voltage drop across the resistor R is maintained to be lower than that across the resistor r, so far as the coefficient $\alpha$ is not larger than 200.

Assuming the coefficient $\alpha$ equals 2, i.e., $\alpha=2$, the constant current flowing into a constant current source $I_{BD}$ through the differential amplifier DA of each nonselection bit line pair can be halved. This makes it possible to remarkably reduce the power consumption in a highly dense semiconductor memory circuit having a great number (N) of bit line pairs. This is because, in such a highly dense memory circuit, the effect for halving the constant current is amplified $(N-1)$ times, since $(N-1)$ bit line pairs are not selected. Thus, it is clear that the semiconductor memory circuit is effective not only for high speed operation as previously mentioned, but also for lower power consumption.

Figure 4 depicts waveforms representing level changes at the output points $B_1$ and $B_2$ in the circuit of Fig. 3. It should be understood that the output points $B_1$ and $B_2$ are taken as examples so as to conform with the previously mentioned example and that identical level changes may take place in any two bit line pairs which change in "selection" to "nonselection" and "nonselection" to "selection". Further, in Fig. 4, the voltage levels of points $B_1$ and $B_2$ are guaranteed to change as shown by the lines 21, 23 and the lines 24, 25 of Fig. 2, respectively. Thus, it is guaranteed that the level difference between the output points $B_1$ and $B_2$ reaches the predetermined value of $\Delta v$ with only a time delay of t after a cross point 41 therebetween and thereby guaranteed that the semiconductor memory circuit of Fig. 3 operates always at a high operation speed.

Referring again to Fig. 3, a resistor R' is connected between the base and emitter of the newly employed transistor $Q_3$. The resistor R' is not an essential constituent of the present invention, however, if used, it prevents undesired oscillation in the bit line driver circuits. Such oscillation is liable to occur due to the very high amplification factor provided by the Darlington circuit ($Q_2$, $Q_3$).

Further, in Fig. 3, it should be noted that the use of the transistor $Q_3$ instead of the diode $D_1$ in each bit line driver circuit does not necessitate any angle change in the structure of the integrated circuits (IC's) for fabricating the prior art semiconductor memory circuit. This is because, in the IC's, each diode $D_1$ is obtained by shorting a base and a collector of a transistor. Therefore, each transistor $Q_3$ according to the present invention is already formed in the IC.

As explained above in detail, according to the present invention, there is realized a semiconductor memory circuit which guarantees continuous high speed operation and, in addition, enables low power consumption.

**Claims**

1. A semiconductor memory circuit comprising:

a plurality of bit line pairs (BL1, BL2, ... BLn); a plurality of word line pairs (WL); a plurality of memory cells (MC) connected to the bit line pairs (BL) and word line pairs (WL); bit line switching transistor pairs (Q11, Q21, ... Qn1) connected in series with their respective bit line pairs (BL1, BL2, ... BLn); constant current sources (IB) connected to the emitters of the bit line switching transistor (Q11, Q21, ... Qn) at one side of each of the bit line switching transistor pairs and to emitters of the bit line switching transistors at the other side of each of the bit line switching transistors, respectively; bit line driver circuits (BD) operative to supply their outputs to the bases, connected in common, of the transistors forming the bit line switching transistor pairs (Q11, Q21, ... Q2n); and a discharge path connected to the commonly connected bases, in which each of the bit line driver circuits (BD) includes a first transistor (Q2) being driven in accordance with a corresponding bit line selection address input and a level shift means (D1, Figure 1) connected in series between the first transistor (Q2) and commonly connected bases of the corresponding one of the pairs of bit line switching transistors (BL1, BL2, ... BLn) for shifting a voltage level, the base of the first transistor receiving base current, via a first resistor, (R), from a power (V), characterised in that the level shift means in each of the bit line driver circuits (BD') is formed by a second transistor (Q3, Figure 3) having a base operatively connected to the emitter of the first transistor (Q2) and an emitter operatively connected to the commonly connected bases of the corresponding one of the pairs of bit line switching transistors (BL1, BL2, ... BLn) to provide an amplification factor of $\beta$.

2. A semiconductor memory circuit according to claim 1, wherein the resistance value (R) of the first resistor (R) is higher than the resistance value (r) of a resistor, which would be needed to supply a predetermined base current to the commonly-connected bases without using the second transistor (Q3), where $R=\alpha r$, the coefficient $\alpha$ being selected to be lower than the value of the amplification factor $\beta$.

3. A semiconductor memory circuit according to claim 1 or 2, wherein a second resistor (R') is further connected between the base and emitter of the second transistor (Q3) in each of the bit line driver circuits (BD') for preventing undesired oscillation generated in each of the first (Q2) and second (Q3) transistors.

**Patentansprüche**

1. Halbleiterspeicherschaltung mit:
einer Vielzahl von Bitleitungspaaren (BL1, BL2, ... BLn); einer Vielzahl von Wortleitungspaaren (WL); einer Vielzahl von Speicherzellen (MC), die mit den Bitleitungspaaren (BL) und Wortleitungspaaren (WL) verbunden sind; Bitleitungs-Schaltungstransistorpaaren (Q11, Q21, ... Qn1), die in Reihen mit den jeweiligen Bitleitungspaaren (BL1, BL2, ... BLn) verbunden sind; Konstantstromquel-

7

0 107 912

8

len (IB), die mit den Emittern des Bitleitungs-Schaltungstransistors (Q11, Q21, ... Qn) an einer Seite von jedem der Bitleitungs-Schaltungstransistorpaare bzw. mit den Emittern der Bitleitungs-Schaltungstransistoren an der anderen Seite von jedem der Bitleitungs-Schaltungstransistoren verbunden sind; Bitleitungs-Treiberschaltungen (BD), die operativ werden, um ihre Ausgänge den Basen, die gemeinsam angeschlossen sind, von den Transistoren zuzuführen, die die Bitleitungs-Schaltunstransistorpaare (Q11, Q21 ... Q2n) bilden; und einem Entladungsweg, der mit den gemeinsam verbundenen Basen verbunden ist, bei dem jede der Bitleitungs-Treiberschaltungen (BD) einen ersten Transistor (Q2) umfaßt, der in Übereinstimmung mit einem entsprechenden Bitleitungs-Auswahladresseneingang und einer Pegelverschiebeeinrichtung (D1, Fig. 1) getrieben wird, die in Reihe zwischen dem ersten Transistor (Q2) angeschlossen sind und gemeinsam mit den Basen des entsprechenden der Paare von Bitleitungs-Schaltungstransistoren (BL1, BL2, ... BLn) verbunden sind, um einen Spannungspegel zu verschieben, wobei die Basis des ersten Transistors den Basisstrom über einen ersten Widerstand (R) von einer Energiequelle (V) empfängt, dadurch gekennzeichnet, daß die Pegelverschiebeeinrichtung in jeder Bitleitungs-Treiberschaltung (BD') durch einen zweiten Transistor (Q3, Fig. 3) gebildet ist, der eine Basis hat, die wirkungsmäßig mit dem Emitter des ersten Transistors (Q2) verbunden ist, und einen Emitter, der wirkungsmäßig mit den gemeinsam angeschlossenen Basen des entsprechenden der Paare von Bitleitungs-Schaltungstransistoren (BL1, BL2, ... BLn) verbunden ist, um den Verstärkungsfaktor $\beta$ zu liefern.

2. Halbleiterspeicherschaltung nach Anspruch 1, bei der der Widerstandswert (R) des ersten Widerstands (R) höher als der Widerstandswert (r) eines Widerstands ist, der erforderlich wäre, um einen vorbestimmten Basisstrom zu den gemeinsam angeschlossenen Basen zu liefern, ohne den zweiten Transistor (Q3) zu benutzen, wobei R=$\alpha$r, und der Koeffizient $\alpha$ so ausgewählt ist, daß er kleiner als der Verstärkungsfaktor $\beta$ ist.

3. Halbleiterspeicherschaltung nach Anspruch 1 oder 2, bei der der zweite Widerstand (R') ferner zwischen der Basis und dem Emitter des zweiten Transistors (Q3) in jeder der Bitleitungs-Treiberschaltungen (BD') angeschlossen ist, um unerwünschte Oszillation zu verhindern, die in jedem der ersten (Q2) und zweiten (Q3) Transistoren erzeugt wird.

**Revendications**

1. Circuit de mémoire à semi-conducteurs comportant plusieurs paires de lignes de bits (BL1, BL2 ... BLn); plusieurs paires de lignes de mots (WL); plusieurs cellules demémoire (MC) connectèes aux paires de lignes de bits (BL) et aux paires de lignes de mots (WL), des paires de transistors de commutation de lignes de bits (Q11, Q21 ... Qn1) connectés en série avec leurs paires de lignes de bits respectives (BL1, BL2 ... BLn); des sources de courant constant ($\beta$) connectées aux émetteurs des transistors de commutation de lignes de bits (Q11, Q21 ... Qn) sur un côté de chacune des paires de transistors de commutation de lignes de bits et aux émetteurs des transistors de commutation de lignes de bits à l'autre côté de chacun des transistors de commutation de lignes de bits respectivement, des circuits d'attaque ds lignes de bits (BD) ayant comme fonction de fournir leurs sorties aux bases, connectées, en commun, des transistors formant les paires de transistors de commutation de lignes de bits (Q11, Q21 ... Q2n); et un circuit de décharge connecté aux bases connectées, en commun dans lequel chacun des circuits d'attaque de lignes de bits (BD) comporte un premier transistor (Q2) commandé en fonction d'une entrée d'adresse de sélection de lignes de bits correspondants et un dispositif de décalage de niveau (D1, Fig. 1) connecté en série entre le premier transistor (Q2) et les bases connectées en commun de l'une correspondante des paires de transistors de commutation de lignes de bits (BL1, BL2 ... BLn) pour décaler un niveau de tension, la base du premier transistor recevant le courant de base, par une première résistance (R) provenant d'une source d'alimentation (V), caractérisé en ce que le dispositif de décalage de niveau dans chacun des circuits d'attaque de lignes de bits (BD') est formé par un second transistor (Q3, Fig. 3) ayant une base connectée opérationnellement a l'émetteur du premier transistor (Q2) et un émetteur connecté opérationnellement aux bases connectées en commun de l'une correspondante des paires de transistors de commutation de lignes de bits (BL1, BL2 ... BLn) pour obtenir un facteur d'amplification ($\beta$).

2. Circuit de mémoire à semi-conducteurs selon la revendication 1, dans lequel la valeur de résistance (R) de la première existance (R) est supérieure à la valeur de résistance (r) d'une résistance qui serait nécessaire pour fournir un courant de base dèterminé aux bases connectées en commun sans utiliser le second transistor (Q3) où R=$\alpha$r et le coefficient $\alpha$ étant choisi pour inférieure à la valeur de facteur d'amplification.

3. Circuit de mémoire à semi-conducteurs selon la revendication 1 ou 2, dans lequel une seconde résistance (R') est en outre connectée entre la base et l'émetteur du second transistor (Q3) dans chacun des circuits d'attaque de lignes de bits (BD') éviter une oscillation indésirable produite en chacun du premier (Q2) et du second (Q3) transistors.

# Fig. I

# Fig. 2

# Fig. 3

# Fig. 4